# EUROPEAN PATENT APPLICATION

(11) **EP 4 775 909 A1**
(43) Date of publication of application: **15.07.2026**
(21) Application number: 24861826.6
(22) Date of filing: 21.08.2024
(51) Int. Cl.: F27D 1/18, C30B 31/06, H01L 21/22

(54) **FURNACE DOOR STRUCTURE FOR DIFFUSION FURNACE, AND DIFFUSION FURNACE**

(30) Priority: 07.09.2023 CN 202311156854; 26.12.2023 CN 202311814692
(71) Applicant: Jiangsu Leadmicro Nano-Technology Co., Ltd., Wuxi, Jiangsu 214111 (CN)
(72) Inventor: MAO, Wenrui, Wuxi, Jiangsu 214111 (CN); CHEN, Cheng, Wuxi, Jiangsu 214111 (CN); PU, Xiwei, Wuxi, Jiangsu 214111 (CN); ZHANG, Kun, Wuxi, Jiangsu 214111 (CN)
(74) Representative: van Breda, Jacobus
(86) International application number: PCT/CN2024/113564
(87) International publication number: WO 2025/050982

(57) **Abstract**

A furnace door structure for a diffusion furnace, and a diffusion furnace. The furnace door structure comprises a metal furnace door, a hanging assembly, and a heat radiation blocking piece, and the metal furnace door is movably connected to the heat radiation blocking piece by means of the hanging assembly. The heat radiation blocking piece in the present invention is hung on the metal furnace door to form a combined furnace door structure, thereby simultaneously avoiding the fragility of a furnace door made of a quartz material and the contamination of a furnace door made of a metal material to a diffusion process. Due to the use of hanging installation, installation and disassembly of the heat radiation blocking piece and the metal furnace door are easier, and adjustment is more convenient.

## Description

The present application claims priorities to the following two Chinese patent applications, both of which are incorporated herein by reference.
1) Chinese Patent Application No. 202311156854.4, titled "FURNACE DOOR STRUCTURE FOR DIFFUSION FURNACE, AND DIFFUSION FURNACE", filed with the China National Intellectual Property Administration on September 7, 2023; and
2) Chinese Patent Application No. 202311814692.9, titled "FURNACE DOOR STRUCTURE FOR DIFFUSION FURNACE, AND DIFFUSION FURNACE", filed with the China National Intellectual Property Administration on December 26, 2023.

### FIELD

The present application relates to the technical field of photovoltaic production equipment, and in particular to a furnace door structure for a diffusion furnace and to a diffusion furnace having the furnace door structure.

### BACKGROUND

The diffusion furnace body in the related art includes a heating furnace and a quartz tube chamber, with a furnace port flange provided at a front end of the quartz tube chamber, and an inlet pipe and an exhaust pipe provided at a rear end of the quartz tube chamber. When the silicon wafer carrier and the silicon wafer are transferred into the quartz tube chamber, the furnace door is moved laterally to press against the furnace port flange at the front end of the quartz tube chamber. A furnace door sealing ring is arranged between the furnace door and the furnace port flange to seal the quartz tube chamber. In current soft landing process equipment for diffusion furnaces, the furnace door is typically made of quartz or metal materials. In the case that the furnace door is made of quartz material, the furnace door is prone to cracking during its movement or compression when sealing the quartz tube chamber due to the brittleness of quartz material. In the case that the furnace door is made of metal material, the escape of metal impurities during the high-temperature diffusion process after the furnace door is closed, may cause contamination to the diffusion process occurring inside the quartz tube chamber.

### SUMMARY

The technical issue to be addressed by the present application is to overcome the above-mentioned shortcomings of the related art by providing a furnace door structure for a diffusion furnace that is easy to mount and disassemble and is convenient to adjust.

Another technical issue to be addressed by the present application is to overcome the above-mentioned shortcomings of the related art by providing a diffusion furnace having a furnace door that is easy to mount and disassemble and is safe and reliable.

A furnace door structure for a diffusion furnace is provided according to the present application, which includes a metal furnace door, a suspension assembly, and a thermal radiation barrier. The metal furnace door is moveably connected to the thermal radiation barrier through the suspension assembly.

The furnace door structure for a diffusion furnace according to the present application further has the following additional technical features.

Furthermore, the suspension assembly includes a support plate and multiple adjustable support seats, the support plate is mounted on an outer side of the thermal radiation barrier, and multiple clamping slots are formed in the support plate. The multiple adjustable support seats are disposed on an inner side of the metal furnace door and are movably connected to the multiple clamping slots in one-to-one correspondence.

Furthermore, the support plate has a shape comprising, but not limited to a T-shape, a triangular shape, or a quadrilateral shape.

Furthermore, the number of clamping slots is two, three, or four, and the multiple clamping slots are evenly or symmetrically arranged around an axis of the support plate.

Furthermore, each clamping slot is semicircular or gourd-shaped.

Furthermore, each adjustable support seat includes a hollow base, a top plate and a bottom plate mounted inside the hollow base. The hollow base is mounted on the inner side of the metal furnace door, the top plate extends out of the hollow base, and an adjusting spring is arranged between the top plate and the bottom plate. The hollow base is provided with a protruding ring, which is configured to abut against an inner side of the support plate when the hollow base is engaged into the plurality of clamping slots.

Furthermore, an elasticity adjusting screw is mounted on the bottom plate and is configured to adjust a distance between the bottom plate and the top plate so as to adjust an elasticity of the adjusting spring.

Furthermore, an extension adjusting screw and a locking nut engaged on the extension adjusting screw are disposed on the top plate, and the locking nut extends beyond the top plate and abuts against the thermal radiation barrier.

Furthermore, an outer edge of the thermal radiation barrier is provided thereon with a plurality of segmented limiting flanges, and there is a gap between adjacent limiting flanges. A peripheral portion of the support plate is pressed into the gap and rotated to abut against the limiting flange. Multiple anti-rotation limiting members are mounted on the support plate to prevent relative rotation between the thermal radiation barrier and the support plate.

Furthermore, multiple elastic clips are provided on an inner side of the support plate, which are pressed against an inner side of the limiting flange of the thermal radiation barrier.

Furthermore, the thermal radiation barrier includes a shell made of quartz, and an opaque high-temperature resistant material filled in the shell.

Furthermore, the metal furnace door is provided with an inlet pipe, and an inert gas is charged through the inlet pipe into a gap between the metal furnace door and the thermal radiation barrier.

Furthermore, the multiple adjustable support seats are configured to be adjustable from outside of the metal furnace door to make thermal radiation barrier parallel to the metal furnace door. Each adjustable support seat includes a support rod, an axial adjusting mechanism, and an elasticity adjusting mechanism. The axial adjusting mechanism is configured to adjust a distance between the support rod and the thermal radiation barrier from the outside of the metal furnace door, and the elasticity adjusting mechanism is configured to elastically support the support rod and adjust an elasticity of the multiple adjustable support seats from the outside of the metal furnace door.

Furthermore, each adjustable support seat further includes a support member and an adjustable limiting member, the support rod is connected to the support member at one end and to the adjustable limiting member at the other end. The support members is provided with a bayonet joint, and the multiple clamping slots of the support plate are configured to be clamped to the corresponding bayonet joint.

Furthermore, the bayonet joint of the support member is annular and has a Y-shaped cross section.

Furthermore, the axial adjusting mechanism includes an external thread formed on an outer wall of the adjustable limiting member and a rotating portion, and the adjustable limiting member is threadedly connected to the metal furnace door through the external thread.

Furthermore, a nut seat is fixed on an outer surface of metal furnace door, and the nut seat is provided with an internal thread adapted to engage with the external thread of the adjustable limiting member.

Furthermore, a portion of each adjustable support seat located outside the metal furnace door is arranged in a sealing chamber formed by a sealing base and a sealing cover plate, and a sealing ring is provided between contact surfaces of the sealing base and the sealing cover plate.

Furthermore, a sealing groove is formed in the contact surface of the sealing base or of the sealing cover plate, and the sealing ring is mounted in the sealing groove which is distanced from the outer surface of the metal furnace door.

Furthermore, the elasticity adjusting mechanism includes an internal thread formed on an inner wall of the adjustable limiting member, an adjusting spring and a locking nut are disposed inside the adjustable limiting member, and the nut seat is formed with an external thread adapted to engage with the internal thread of the adjustable limiting member. The adjusting spring has one end abutting against the support rod and the other end abutting the adjusting spring.

Furthermore, an end portion of the support rod located in an inner chamber of the adjustable limiting member has an enlarged diameter portion, an end portion of the adjustable limiting member close to the metal furnace door is provided with a limiting portion adapted to engage with the enlarged diameter portion of the support rod.

Furthermore, the metal furnace door is provided with a first hole for the support rod to pass through and a second hole for accommodating an end portion of the adjustable limiting member close to the metal furnace door, and the second hole has a hole diameter greater than that of the first hole so that the second hole and the first hole form a stepped hole.

Compared with the related art, the furnace door structure for the diffusion furnace and the diffusion furnace according to the present application have the following advantages: first, in the present application, the thermal radiation barrier is suspended on the metal furnace door to form a combined furnace door structure, which can simultaneously avoid the fragility of quartz material or the contamination of the metal material to the diffusion process, when being used as the furnace door. Due to the mounting method in a suspension manner, it is easy to mount and disassemble the thermal radiation barrier and the metal furnace door, and the adjustment is convenient. Further, by the adjustable support seat of the present application, the buffering forces on the thermal radiation barrier in various directions and positions can be adjusted, and the posture of the suspension thermal radiation barrier can also be adjusted so that the thermal radiation barrier is arranged parallel to the metal furnace door in the vertical direction to prevent the thermal radiation barrier from being compressed or collided to be cracked.

### BRIEF DESCRIPTION OF THE DRAWINGS

FIG. 1 is a sectional view of a diffusion furnace according to the present application;
FIG. 2 is a perspective view of a furnace door according to the present application;
FIG. 3 is another perspective view of the furnace door according to the present application;
FIG. 4 is an exploded perspective view of the furnace door according to the present application;
FIG. 5 is a perspective view of a thermal radiation barrier according to the present application;
FIG. 6 is a perspective view of a support plate according to the present application;
FIG. 7 is a perspective view of the support plate according to the present application during mounting;
FIG. 8 is another perspective view of the support plate according to the present application during mounting;
FIG. 9 is a front view of an adjustable support seat according to the present application;
FIG. 10 is a sectional view of the adjustable support seat according to the present application;
FIG. 11 is a schematic structural view of a furnace door structure according to another embodiment of the present application;
FIG. 12 is a schematic structural view of a metal furnace door on an inner side thereof;
FIG. 13 is a schematic view showing a process of suspension a quartz door on the metal furnace door;
FIG. 14 is a sectional view of the furnace door;
FIG. 15 is a schematic partially enlarged view in FIG. 14;
FIG. 16 is a right-side view of the furnace door in FIG. 14;
FIG. 17 is a sectional view of an adjustable limiting member in FIG. 15;
FIG. 18 is a perspective view of the adjustable limiting member in FIG. 15;
FIG. 19 is a sectional view of a locking nut in FIG. 15; and
FIG. 20 is a perspective view of the locking nut in FIG. 15.

Reference numerals in the figures are listed as follows:

| | | | |
|---|---|---|---|
| 1. | metal furnace door, | 11. | sealing ring, |
| 12. | inlet pipe, | 2. | thermal radiation barrier, |
| 21. | limiting flange, | 22. | protruding ring, |
| 3. | suspension assembly, | 31. | support plate, |
| 311. | clamping slot, | 312. | elastic clip, |
| 313. | anti-rotation limiting member, | 32. | adjustable support seat, |
| 321. | hollow base, | 322. | top plate, |
| 323. | bottom plate, | 324. | adjusting spring, |
| 325. | elasticity adjusting screw, | 326. | extension adjusting screw, |

| | | | |
|---|---|---|---|
| 327. | locking nut, | 329. | protruding ring, |
| 10. | heating furnace, | 20. | quartz tube chamber, |
| 30. | furnace port flange, | 412. | sealing base, |
| 50. | adjustable support seat, | 51. | support member, |
| 511. | bayonet joint, | 52. | support rod, |
| 53. | nut seat, | 54. | adjustable limiting member, |
| 541. | external thread, | 542. | rotating portion, |
| 543. | internal thread, | 55. | locking nut, |
| 56. | adjusting spring, | 71. | sealing cover plate, |
| 72. | base sealing ring. | | |

### DETAILED DESCRIPTION OF THE EMBODIMENTS

To clearly illustrate the solution of the present application, preferred embodiments are given below and detailed described in conjunction with the accompanying drawings. The following explanation is merely exemplary in nature and not intended to limit the application or use of the present application. It should be understood that in all the figures, corresponding reference numerals represent for the same or corresponding components and features.

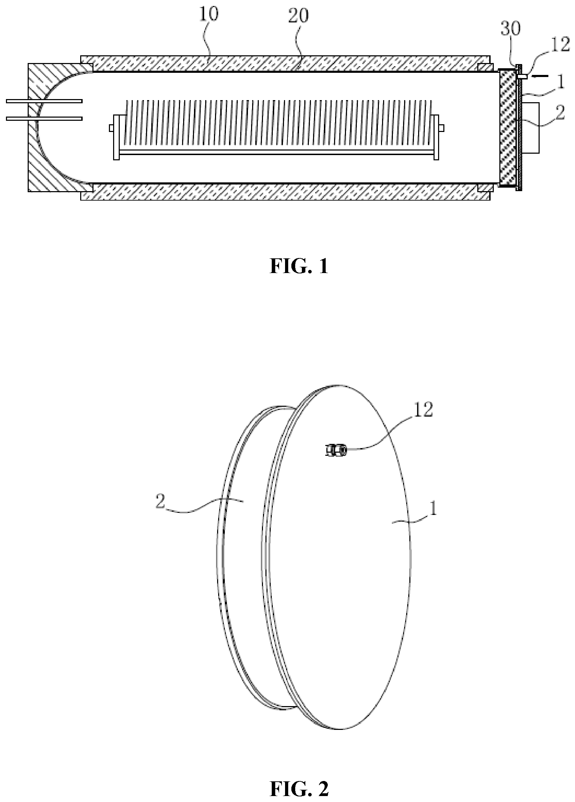

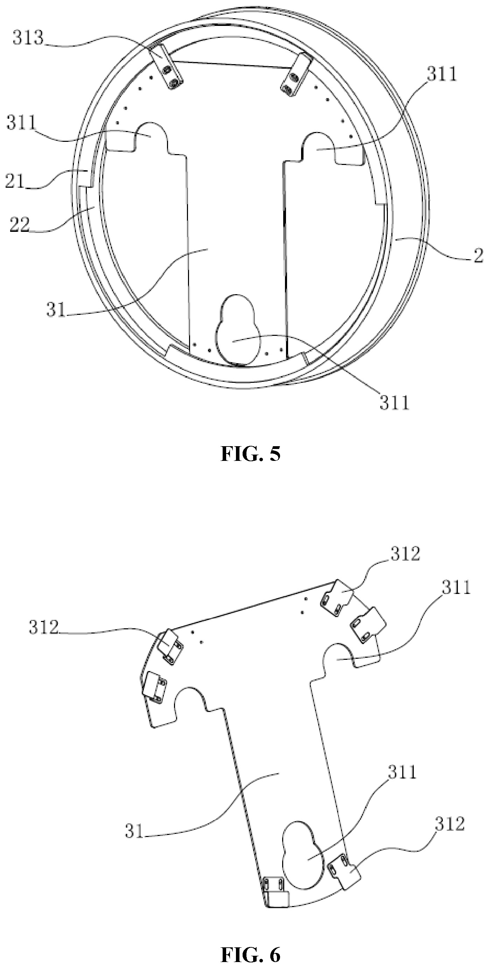

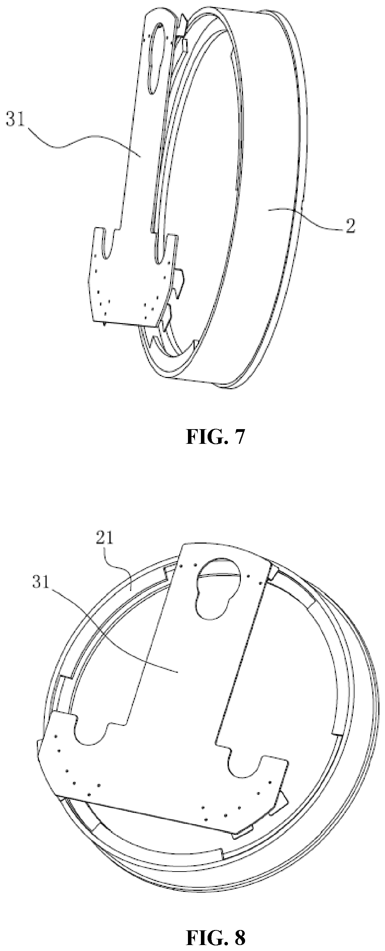

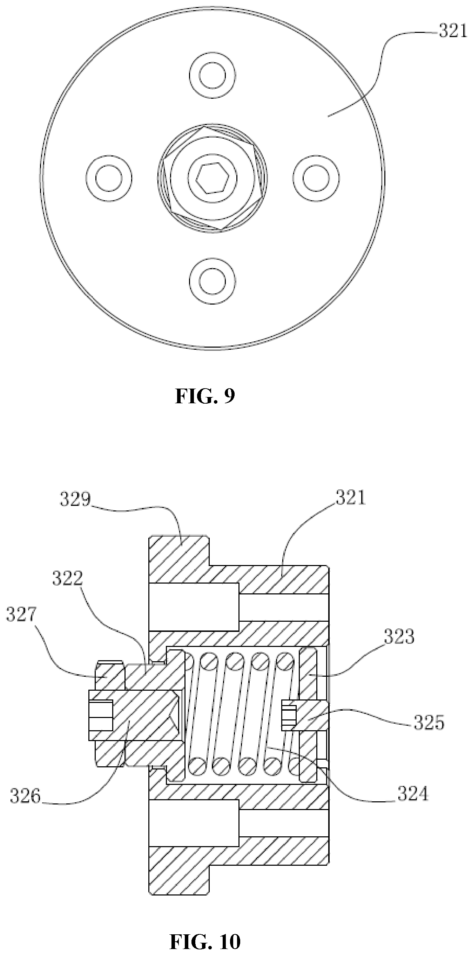

As shown in FIGS. 1 to 10, a furnace door structure for a diffusion furnace is provided according to the present application, which includes a metal furnace door 1, a suspension assembly 3, and a thermal radiation barrier 2. The metal furnace door 1 is moveably connected to the thermal radiation barrier 2 through the suspension assembly 3. To avoid the fragility of quartz material or the contamination of the metal material to the diffusion process, when being used as the furnace door, a combined furnace door structure is provided in the present application, which includes the metal furnace door 1, with the thermal radiation barrier 2 suspended on a front end of the metal furnace door 1. A body of the thermal radiation barrier 2 is a quartz door, which is made of quartz material and filled with opaque and high-temperature resistant materials, such as glass fiber. These materials do not cause contamination to the diffusion process. In the present application, the above structure is mounted in a suspending manner, the installation and disassembly of the thermal radiation barrier 2 are easy, and the adjustment is convenient.

Referring to FIGS. 1 to 10, in the above embodiment of the present application, the suspension assembly 3 includes a support plate 31 and multiple adjustable support seats 32. The support plate 31 is mounted on an outer side of the thermal radiation barrier 2, and multiple clamping slots 311 are formed in the support plate 31. The adjustable support seats 32 are located on an inner side of the metal furnace door 1 and are movably connected to the clamping slots 311 in one-to-one correspondence. In this embodiment, the support plate 31 is in a T-shape, which mainly includes a post and two cantilever arms located above the post. Each cantilever arm is formed with an open semicircular clamping slot, and the post is formed with a gourd-shaped clamping slot. There are three adjustable support seats 32, two are above and one is below. The two upper adjustable support seats 32 are respectively connected to two open clamping slots, and the one lower adjustable support seat 32 is connected to the gourd-shaped clamping slot. In the present application, the shape of the support plate 31 may be in various structural forms, including but not limited, having two corners, triangular, or quadrilateral. In this embodiment, a triangular structure is provided, forming a T-shaped structure. It may also adopt structures such as I-shaped, Y-shaped, triangular, quadrilateral, etc., as well as structures such as elliptical, rectangular, square, trapezoidal, etc. The number of clamping slots 311 is the same as the number of adjustable support seats 32, which may be two, three, or four, etc. The clamping slots 311 are evenly or symmetrically arranged around an axis of the support plate 31. For the support plate 31, it is easy to manufacture the clamping slot structures thereon and facilitates suspension. In the present application, the clamping slots 311 may be all formed in semicircular shape or in a gourd shape.

Referring to FIGS. 1 to 10, in the above embodiment of the present application, the outer edge of the thermal radiation barrier 2 is provided thereon with multiple segmented limiting flanges 21, and there is a gap between adjacent limiting flanges 21. A peripheral portion of the support plate 31 is pressed into the gap and rotated by a certain angle to abut against the limiting flanges 21. In this embodiment, a protruding ring 22 is further provided inside the limiting flange 21, and a mounting groove is formed between the protruding ring 22 and the limiting flange 21. The support plate 31 is clamped into the mounting groove, and the above structure facilitates the mounting and fixation of the support plate 31. Alternatively, the protruding ring 22 may be omitted in the present application, and the mounting groove may be formed between the limiting flange 21 and an inner wall of the thermal radiation barrier 2, which can still fix the support plate 31. The limiting flanges 21 are configured as a multi-segment structure, which facilitates of mounting the support plate 31.

Referring to FIGS. 1 to 10, in the above embodiment of the present application, multiple elastic clips 312 are provided on the inner side of the support plate 31, which are pressed against an inner side of the limiting flange 21 of the thermal radiation barrier 2. In this embodiment, the mounting groove structure formed by the protruding ring 22 and the limiting flange 21 is adopted, and thus the elastic clip 312 is pressed against the protruding ring 22. In that case, the protruding ring 22 is configured as a part of the inner wall structure of the thermal radiation barrier 2. The elastic clip 312 functions as an elastic support, preventing the support plate 31 from shaking in the mounting groove.

Referring to FIGS. 1 to 10, in the above embodiment of the present application, multiple anti-rotation limiting members 313 are mounted on the support plate 31, which abut against the end portion of the limiting flange 21. The anti-rotation limiting members 313 are provided to prevent relative rotation between the thermal radiation barrier 2 and the support plate 31. The anti-rotation limiting member 313 prevents the support plate 31 from rotating after being mounted in place. Multiple mounting holes are provided on the support plate 31. After the support plate 31 is mounted in place, the anti-rotation limiting members 313 are fixed in the mounting holes to prevent the rotation of the support plate 31.

In the present application, when mounting the support plate 31, the elastic clips 312 are mounted in advance, and three corners of the T-shaped support plate 31 are arranged offset from the limiting flanges 21. The three corners of the support plate 31 are inserted into the mounting groove through the gap between adjacent limiting flanges 21, and then the support plate 31 is rotated by a required angle to be clamped in the mounting groove formed by the limiting flange 21 and the protruding ring 22, and then the anti-rotation limiting member 313 is mounted.

Referring to FIGS. 1 to 10, in the above embodiment of the present application, the adjustable support seat 32 includes a hollow base 321, and a top plate 322 and a bottom plate 323 mounted inside the hollow base 321. An adjusting spring 324 is provided between the top plate 322 and the bottom plate 323. The hollow base 321 is mounted on the inner side of the metal furnace door 1, and the top plate 322 extends out of the hollow base 321. The hollow base 321 is provided with a protruding ring 329, which is configured to abut against the inner side of the support plate 31 when the hollow base 321 is engaged into the corresponding clamping slot 311. The protruding ring 329 functions of position limiting, preventing the hollow base 321 from disengaging when being engaged into the clamping slot 311. For the suspension structure of the thermal radiation barrier 2, in case of movement or being compressed, the adjustable support seats 32 at different locations of the metal furnace door 1 apply different support forces on the thermal radiation barrier 2. In addition to the vertical support of the adjustable support seat 32 for the thermal radiation barrier 2, the adjustable support seat 32 may be further subjected to horizontal compression or tension from the thermal radiation barrier 2. By adjusting the elasticity of the adjusting springs 324 of the adjustable support seats 32 at different locations, the buffering forces on the thermal radiation barrier 2 in different directions and positions can be adjusted to achieve a better buffering performance of the thermal radiation barrier 2 in different directions and positions, preventing the thermal radiation barrier 2 from being cracked due to compression.

Referring to FIGS. 1 to 10, in the above embodiment of the present application, an elasticity adjusting screw 325 is mounted on the bottom plate 323, which is configured to move the bottom plate 323 in an inner chamber of the hollow base 321. The elasticity adjusting screw 325 adjusts a distance between the bottom plate 323 and the top plate 322, thereby adjusting the elasticity of the adjusting spring 324. The elasticity adjusting screw 325 can mainly adjust the distance between the bottom plate 323 and the top plate 322, thereby adjusting the elasticity of the adjusting spring 324. In the present application, the top plate 322 can slide along the inner chamber of the hollow base 321, providing a buffering effect on the thermal radiation barrier 2. The elasticity of the adjusting spring 324 can be adjusted to adjust the buffering force.

Referring to FIGS. 1 to 10, in the above embodiment of the present application, an extension adjusting screw 326 and a locking nut 327 threaded on the extension adjusting screw 326 are provided on the top plate 322. The locking nut 327 extends beyond the top plate 322 and abuts against the thermal radiation barrier 2. For the suspension thermal radiation barrier 2, there may be a situation that the thermal radiation barrier 2 is not parallel to the metal furnace door 1 in the vertical direction, which is not conducive to maintaining a gas curtain with micro-positive pressure and is likely to cause an end face of the thermal radiation barrier 2 to collide with a step surface inside the quartz tube chamber to be cracked. By adjusting the extension amount of the extension adjusting screw 326 of the adjustable support seat 32 at different locations, the posture of the suspension thermal radiation barrier 2 can be adjusted, so that the thermal radiation barrier 2 can be arranged parallel to the metal furnace door 1 in the vertical direction through the adjustment. In a more optimized structure, the middle portion of the extension adjusting screw 326 may be a hollow structure, which facilitates the insertion of a thinner tightening wrench to adjust the elasticity adjusting screw 325 inside.

Referring to FIGS. 1 to 10, in the above embodiments of the present application, the thermal radiation barrier 2 includes a shell made of quartz, and an opaque high-temperature resistant material filled in the shell. The metal furnace door 1 is provided with an inlet pipe 12, and an inert gas is charged through the inlet pipe 12 into a gap between the metal furnace door 1 and the thermal radiation barrier 2. In this embodiment, the inert gas is nitrogen. To avoid metal contamination of the metal furnace door 1, a nitrogen gas inlet pipe 12 is provided on the metal furnace door 1. The nitrogen gas is charged through the inlet pipe 12 into the gap between the metal furnace door 1 and the thermal radiation barrier 2. The end face of the thermal radiation barrier 2 is close to or attached to the stepped end face inside the quartz tube chamber, forming a gas curtain with micro-positive pressure to prevent the diffusion process gas from reaching this area and corroding the metal furnace door 1, and thereby preventing contamination to the diffusion process.

In the present application, when installing the thermal radiation barrier 2 onto the metal furnace door 1, it is only necessary to align the clamping slots of the thermal radiation barrier 2 with the adjustable support seats 32 on the metal furnace door 1, lift the thermal radiation barrier 2 up by a distance, apply an inward force on the thermal radiation barrier 2, and then lower the thermal radiation barrier 2 down. When disassembling the thermal radiation barrier 2 from the metal furnace door 1, it is only necessary to apply an inward force on the thermal radiation barrier 2, lift the thermal radiation barrier 2 up by a distance, and then remove the thermal radiation barrier 2. After disassembling the thermal radiation barrier 2, the adjustable support seat 32 can be adjusted.

Referring to FIGS. 1 to 10, in an embodiment of the present application, the diffusion furnace includes a heating furnace 10, a quartz tube chamber 20, and a furnace port flange 30 located at an end of the quartz tube chamber 20. A furnace door structure is provided at the furnace port flange 30, which is the furnace door structure described in the above embodiment. The thermal radiation barrier 2 is located in the quartz tube chamber 20, and the metal furnace door 1 abuts against the outer side of the furnace port flange 30. In the present application, the diffusion furnace may be various types of mature products in the related art, and the furnace door structure of the present application may be applicable to all of these types of diffusion furnaces. Therefore, the structure of the diffusion furnace in the present application is not limited to the above structure.

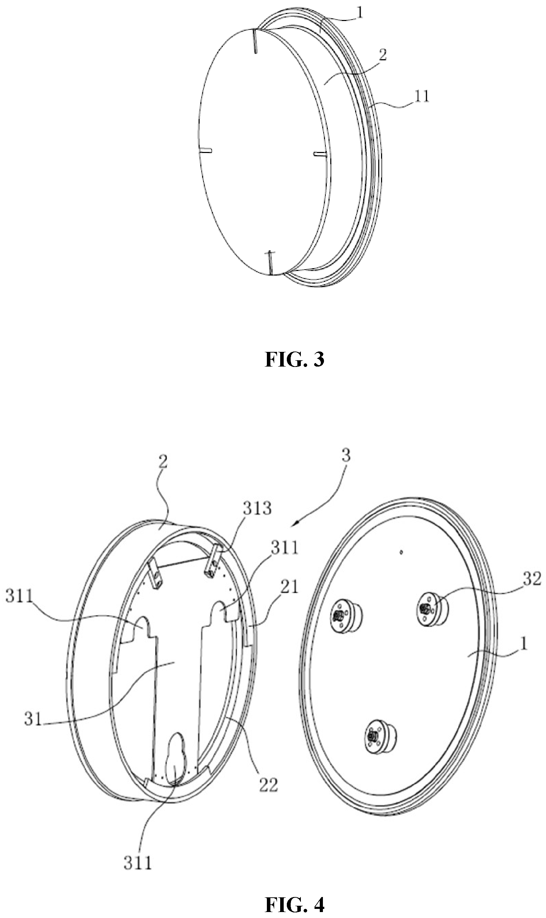

Referring to FIGS. 1 and 3, in the above embodiment of the present application, a sealing ring 11 is further provided on the metal furnace door 1 to seal between the metal furnace door 1 and the furnace port flange 30.

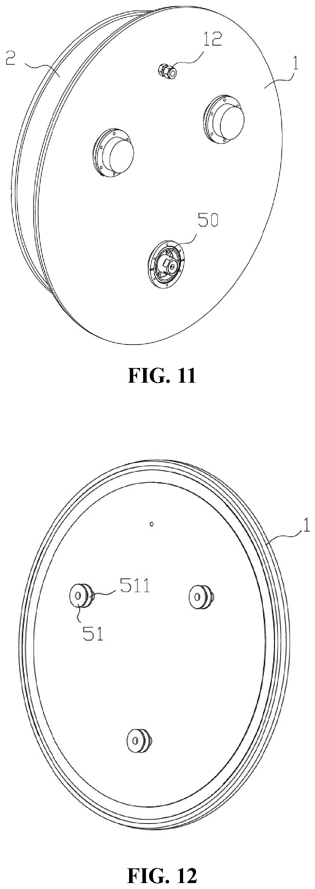

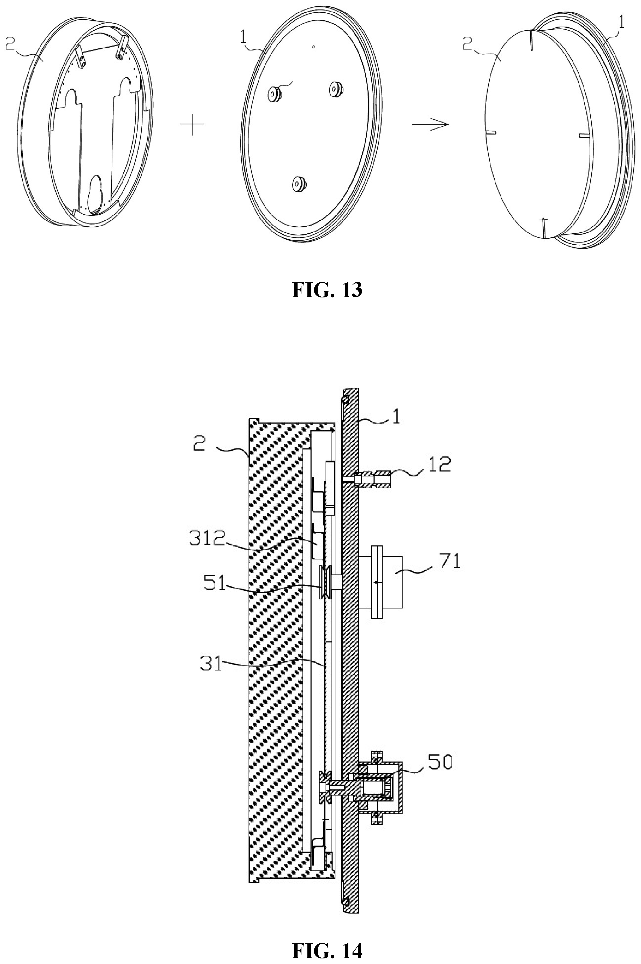

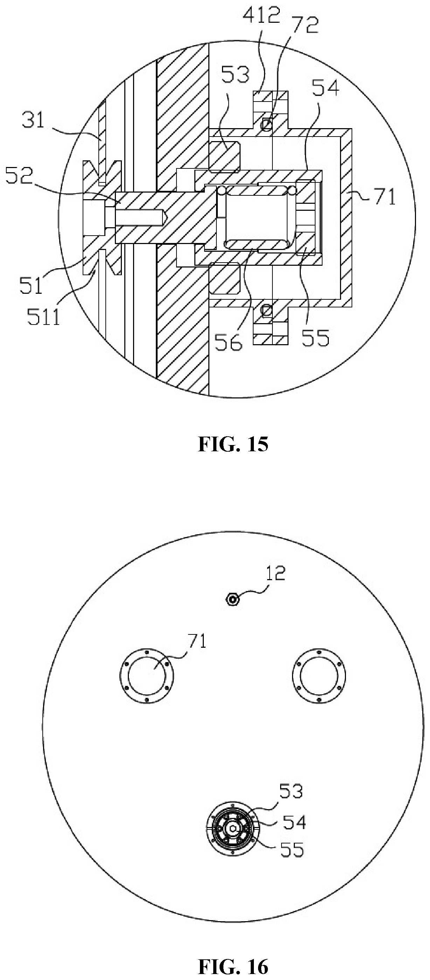

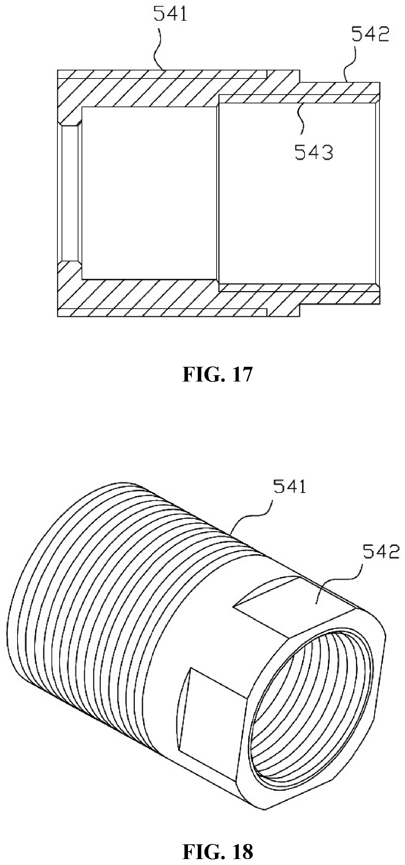

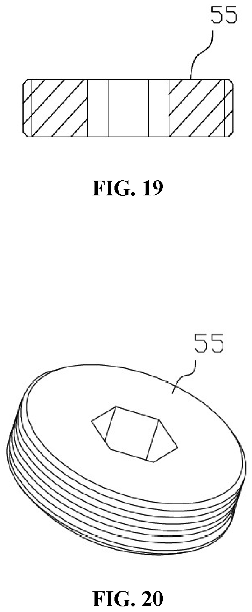

Referring to FIGS. 11 to 20, in another embodiment, multiple support members 51 are provided on the inner side of the metal furnace door 1, and each support member 51 is provided with a corresponding bayonet joint 511. When being connected in a suspension manner, the clamping slot 311 of the support plate 31 is clamped to the bayonet joint 511 of the support member 51, and the weight of the thermal radiation barrier 2 is supported by the support member 51. The bayonet joint 511 of the support member 51 is annular, and the cross section of the circular bayonet joint is Y-shaped.

The support member 51 is mounted on the metal furnace door 1 by the adjustable support seat 50. The number of adjustable support seats 50 may be two, three, or more. In this embodiment, three adjustable support seats 50 are provided, which are distributed in an inverted triangular form.

The adjustable support seat 50 is provided with a support rod 52 and an adjustable limiting member 54. One end of the support rod 52 is connected to the support member 51, and the other end of the support rod 52 is connected to the adjustable limiting member 54. The adjustable limiting member 54 is provided with an axial adjusting mechanism and an elasticity adjusting mechanism. The axial adjusting mechanism is used to adjust the extension length of the support rod 52, and the elasticity adjusting mechanism is used to elastically support the support rod 52 and adjust the elasticity of the support rod 52.

Specifically, the axial adjusting mechanism includes an external thread 541 formed on an outer wall of the adjustable limiting member 54 and a rotating portion 542. The metal furnace door 1 is provided with a first hole for the support rod 52 to pass through and a second hole for accommodating a front end of the adjustable limiting member 54. A hole diameter of the second hole is greater than that of the first hole so that the second hole and the first hole form a stepped hole.

The outer surface of metal furnace door 1 is fixed thereon with a nut seat 53 corresponding to the second hole. The nut seat 53 is provided with an internal thread, and the adjustable limiting member 54 is threadedly connected to the nut seat 53 through the external thread 541 thereof. The axial position of the adjustable limiting member 54 can be adjusted by rotating the rotating portion 542.

One end of the support rod 52 located in the inner chamber of the adjustable limiting member 54 has an enlarged diameter portion and is limited by the necked front end of the adjustable limiting member 54. The elasticity adjusting mechanism includes an internal thread 543 formed on the inner wall of the adjustable limiting member 54, an adjusting spring 56, and a locking nut 55. One end of the adjusting spring 56 abuts against the support rod 52, and the other end of the adjusting spring 56 abuts against the locking nut 55. The inner side of the locking nut 55 is provided thereon with an inner hexagonal hole or square hole, which is configured for a wrench to be inserted for tightening and adjusting the locking nut 55. The position of the locking nut 55 relative to the adjustable limiting member 54 can be adjusted so as to adjust the elasticity of the adjusting spring 56.

A portion of the adjustable support seat 50 located outside the metal furnace door is arranged in a sealing chamber formed by a sealing base 412 and a sealing cover plate 71. The sealing base 412 is welded to the metal furnace door 1, without any leakage in the weld seam. A base sealing ring 72 is provided between the sealing base 412 and the sealing cover plate 71. By compression seal, the inner and outer sides of the furnace door can be isolated with each other to avoid gas leakage.

A sealing groove for mounting the base sealing ring 72 may be formed in the sealing base 412 or the sealing cover plate 71. Since the temperature of the outer surface of the metal furnace door 1 is high while the temperature of the end surface of the sealing base 412 is low, it is required for the contact surface of the base sealing ring 72 to be distanced from the outer surface of the metal furnace door 1. Therefore, by locating the sealing ring 72 far away from the outer surface of the metal furnace door 1, it can prevent the base sealing ring 72 from being damaged by high temperature or shortening the service life.

Alternatively, a vacuum quick-release flange in a clamping or tightening type or other types of flange connections may be provided between the sealing base 412 and the sealing cover plate 71.

For the suspension thermal radiation barrier 2, in case of movement or being compressed, the adjustable support seats 50 at different locations of the metal furnace door 1 apply different support forces on the thermal radiation barrier 2. In addition to the vertical support of the adjustable support seats 50 for the thermal radiation barrier 2, the adjustable support seats 50 may be further subjected to horizontal compression or tension from the thermal radiation barrier 2. By adjusting the elasticity of the adjusting springs 56 of the adjustable support seats 50 at different locations, the buffering force on the thermal radiation barrier 2 in various directions and positions can be adjusted to achieve a better buffering performance of the thermal radiation barrier 2 in various directions and positions, preventing the thermal radiation barrier 2 from being cracked due to compression.

For the suspension thermal radiation barrier 2, there may be a situation that the thermal radiation barrier 2 is not parallel to the metal furnace door 1 in the vertical direction, which is not conducive to maintaining the gas curtain with micro-positive pressure and is likely to cause the end face of the thermal radiation barrier 2 to collide with the step surface inside the quartz tube chamber 20 to be cracked. By adjusting the extension amount of the adjustable limiting member 54 of the adjustable support seat 50 at different locations, the suspension thermal radiation barrier 2 can be arranged parallel to the metal furnace door 1 in the vertical direction.

When installing the thermal radiation barrier 2 on the metal furnace door 1, it is only necessary to align the clamping slots of the thermal radiation barrier 2 with the adjustable support seats 50 on the metal furnace door 1, lift the thermal radiation barrier 2 up by a distance, apply an inward force on the thermal radiation barrier 2, and then lower the thermal radiation barrier 2 down. When disassembling the thermal radiation barrier 2 from the metal furnace door 1, it is only necessary to apply an inward force on the thermal radiation barrier 2, lift the thermal radiation barrier 2 up by a distance, and then remove the thermal radiation barrier 2. After disassembling the thermal radiation barrier 2, the adjustable support seat 50 can be adjusted.

When adjusting the elasticity of the adjusting spring 56 and the axial position of the adjustable limiting member 54, the adjustment of the locking nut 55 or the adjustable limiting member 54 may be made from the outside of the metal furnace door without removing the suspension thermal radiation barrier 2. After the elasticity of the adjusting spring 56 and the axial position of the adjustable limiting member 54 have been adjusted, the portion of the adjustable support seat 50 outside the metal furnace door is sealed by the base sealing ring 72 and the sealing cover plate 71.

The above embodiments are only preferred solutions of the present application and are not intended to be limiting. Based on these embodiments, targeted adjustments may be made according to actual needs to obtain different implementations. There are numerous implementations, which will not be illustrated in detail herein.

Compared with the conventional furnace door structure in the industry, the furnace door structure of the diffusion furnace has at least the following advantages:
1) It can simultaneously avoid the fragility of quartz material or the contamination of the metal material to the diffusion process, when being used as the furnace door. Moreover, it is easy to mount and disassemble, and its adjustment is convenient.
2) By the adjustable support seat 50, the buffering forces on the thermal radiation barrier 2 in various directions and positions can be adjusted, and the suspension thermal radiation barrier 2 can also be adjusted to be arranged parallel to the metal furnace door 1 in the vertical direction so as to prevent the thermal radiation barrier 2 from being compressed or collided to be cracked.
3) By adjusting the locking nut 55 or the adjustable limiting member 54 from the outside of the metal furnace door 1, the elasticity of the adjusting spring 56 and the axial position of the adjustable limiting member 54 can be adjusted without removing the suspension thermal radiation barrier 2.
4) The portion of the adjustable support seat 50 outside the metal furnace door is arranged in the sealing chamber formed by the sealing base 412 and the sealing cover plate 71. The sealing base 412 is sealedly welded to the metal furnace door 1, and the base sealing ring 72 is provided between the sealing base 412 and the sealing cover plate 71 to achieve the compression seal, which isolates the inner side and the outer side of the furnace door to avoid gas leakage.

In addition to the above furnace door structure of the diffusion furnace, a diffusion furnace is further provided in the present application, which includes a heating furnace 10, a quartz tube chamber 20, and a furnace port flange 30 located at the end portion of the quartz tube chamber. The above furnace door structure is provided at the furnace port flange, and a sealing ring 11 is disposed on the metal furnace door 1 to seal between the metal furnace door 1 and the furnace port flange 30. The rear end of the quartz tube chamber 20 is provided thereon with a furnace chamber inlet pipe and a furnace chamber exhaust pipe. When the silicon wafer carrier and the silicon wafer are transferred into the quartz tube chamber 20, the furnace door is moved laterally to press against the furnace port flange 30 at the front end of the quartz tube chamber 20, and is then sealed with the furnace port flange 30 by the sealing ring 11. The rest structure of the diffusion furnace will not be described herein.

The above provides a detailed introduction to the furnace door structure and diffusion furnace according to the present application. Specific examples are applied herein to explain the principles and implementations of the present application. The above examples are only used to help understand the core idea of the present application. It should be noted that for those skilled in the art several improvements and modifications can be made to the present application without departing from the principles of the present application, and these improvements and modifications also fall within the protection scope of the claims of the present application.

## Claims

1. A furnace door structure for a diffusion furnace, comprising:
a metal furnace door;
a suspension assembly; and
a thermal radiation barrier,
wherein the metal furnace door is moveably connected to the thermal radiation barrier through the suspension assembly.

2. The furnace door structure for the diffusion furnace according to claim 1, wherein
the suspension assembly comprises a support plate and a plurality of adjustable support seats;
the support plate is mounted on an outer side of the thermal radiation barrier, and a plurality of clamping slots are formed in the support plate; and
the plurality of adjustable support seats are disposed on the metal furnace door and are movably connected to the plurality of clamping slots in one-to-one correspondence.

3. The furnace door structure for the diffusion furnace according to claim 2, wherein
the support plate has a shape comprising, but not limited to a T-shape, a triangular shape, or quadrilateral shape.

4. The furnace door structure for the diffusion furnace according to claim 2, wherein
the number of clamping slots is two, three, or four, and the clamping slots are evenly or symmetrically arranged around an axis of the support plate.

5. The furnace door structure for the diffusion furnace according to any one of claims 2 to 4, wherein
each clamping slot is semicircular or gourd-shaped.

6. The furnace door structure for the diffusion furnace according to claim 2, wherein
the plurality of adjustable support seats are disposed on an inner side of the metal furnace door, and each adjustable support seat comprises a hollow base, a top plate and a bottom plate mounted inside the hollow base;
the hollow base is mounted on the inner side of the metal furnace door, the top plate extends out of the hollow base, and an adjusting spring is arranged between the top plate and the bottom plate; and
the hollow base is provided with a protruding ring, which is configured to abut against an inner side of the support plate when the hollow base is engaged into the corresponding clamping slot.

7. The furnace door structure for the diffusion furnace according to claim 6, wherein
an elasticity adjusting screw is mounted on the bottom plate and is configured to adjust a distance between the bottom plate and the top plate so as to adjust an elasticity of the adjusting spring.

8. The furnace door structure for the diffusion furnace according to claim 6, wherein
an extension adjusting screw and a locking nut engaged on the extension adjusting screw are disposed on the top plate, and the locking nut extends beyond the top plate and abuts against the thermal radiation barrier.

9. The furnace door structure for the diffusion furnace according to claim 2, wherein
a plurality of segmented limiting flanges are provided at an outer edge of the thermal radiation barrier, and there is a gap between adjacent limiting flanges; and
a peripheral portion of the support plate is pressed into the gap and rotated to abut against the limiting flange; and
a plurality of anti-rotation limiting members are mounted on the support plate to prevent relative rotation between the thermal radiation barrier and the support plate.

10. The furnace door structure for the diffusion furnace according to claim 9, wherein
a plurality of elastic clips are provided on an inner side of the support plate, which are pressed against an inner side of the limiting flange of the thermal radiation barrier.

11. The furnace door structure for the diffusion furnace according to claim 1, wherein
the thermal radiation barrier comprises a shell made of quartz, and an opaque high-temperature resistant material filled in the shell.

12. The furnace door structure for the diffusion furnace according to claim 1, wherein
an inlet pipe is provided on the metal furnace door, and an inert gas is charged through the inlet pipe into a gap between the metal furnace door and the thermal radiation barrier.

13. The furnace door structure for the diffusion furnace according to claim 2, wherein
the plurality of adjustable support seats are configured to be adjustable from outside of the metal furnace door to make the thermal radiation barrier parallel to the metal furnace door; and
each adjustable support seat comprises a support rod, an axial adjusting mechanism, and an elasticity adjusting mechanism, wherein the axial adjusting mechanism is configured to adjust a distance between the support rod and the thermal radiation barrier from the outside of the metal furnace door, and the elasticity adjusting mechanism is configured to elastically support the support rod and adjust an elasticity of the plurality of adjustable support seats from the outside of the metal furnace door.

14. The furnace door structure for the diffusion furnace according to claim 13, wherein
each adjustable support seat further comprises a support member and an adjustable limiting member, the support rod is connected to the support member at one end and to the adjustable limiting member at the other end; and
the support member is provided with a bayonet joint, and the plurality of clamping slots of the support plate are configured to be clamped to the corresponding bayonet joint.

15. The furnace door structure for the diffusion furnace according to claim 14, wherein
the bayonet joint of the support member is annular and has a Y-shaped cross section.

16. The furnace door structure for the diffusion furnace according to claim 14, wherein
the axial adjusting mechanism comprises an external thread formed on an outer wall of the adjustable limiting member and a rotating portion, and the adjustable limiting member is threadedly connected to the metal furnace door through the external thread.

17. The furnace door structure for the diffusion furnace according to claim 16, wherein
a nut seat is fixed on an outer surface of metal furnace door, and is provided with an internal thread adapted to engage with the external thread of the adjustable limiting member.

18. The furnace door structure for the diffusion furnace according to claim 14, wherein
a portion of each adjustable support seat located outside the metal furnace door is arranged in a sealing chamber formed by a sealing base and a sealing cover plate, and a sealing ring is provided between contact surfaces of the sealing base and the sealing cover plate.

19. The furnace door structure for the diffusion furnace according to claim 18, wherein
a sealing groove is formed in the contact surface of the sealing base or of the sealing cover plate, the sealing ring is mounted in the sealing groove which is distanced from the outer surface of the metal furnace door.

20. The furnace door structure for the diffusion furnace according to claim 14, wherein
the elasticity adjusting mechanism comprises an internal thread formed on an inner wall of the adjustable limiting member, an adjusting spring and a locking nut are disposed inside the adjustable limiting member, and the nut seat is formed with an external thread adapted to engage with the internal thread of the adjustable limiting member; and
the adjusting spring has one end abutting the support rod and the other end abutting the locking nut.

21. The furnace door structure for the diffusion furnace according to claim 14, wherein
an end portion of the support rod located in an inner chamber of the adjustable limiting member has an enlarged diameter portion, and an end portion of the adjustable limiting member close to the metal furnace door is provided with a limiting portion adapted to engage with the enlarged diameter portion of the support rod.

22. The furnace door structure for the diffusion furnace according to claim 14, wherein
the metal furnace door is provided with a first hole for the support rod to pass through and a second hole for accommodating an end portion of the adjustable limiting member close to the metal furnace door, and the second hole has a hole diameter greater than that of the first hole so that the second hole and the first hole form a stepped hole.

23. A diffusion furnace, comprising a heating furnace, a quartz tube chamber, and a furnace port flange located at an end of the quartz tube chamber, wherein
the furnace door structure according to any one of claims 1 to 22 is disposed at the furnace port flange, and
the thermal radiation barrier is located in the quartz tube chamber, and the metal furnace door is located outside the furnace port flange.

24. The diffusion furnace according to claim 23, wherein
a sealing ring is disposed on the metal furnace door to seal between the metal furnace door and the furnace port flange.
